# EUROPÄISCHE PATENTSCHRIFT

(11) **EP 1 307 952 B1**
(45) Veröffentlichungstag und Bekanntmachung des Hinweises auf die Patenterteilung: **28.04.2004**
(21) Anmeldenummer: 00960350.7
(22) Anmeldetag: 10.08.2000
(51) Int. Cl.: H01R 13/658

(54) **SCHIRMBLECH, INSBESONDERE FÜR OPTO-ELEKTRONISCHE TRANSCEIVER**
SHIELD, ESPECIALLY FOR OPTOELECTRONIC TRANSCEIVERS
TOLE DE BLINDAGE, EN PARTICULIER POUR EMETTEUR-RECEPTEUR OPTOELECTRONIQUE

(43) Veröffentlichungstag der Anmeldung: 07.05.2003
(73) Patentinhaber: Infineon Technologies AG, 81669 München (DE)
(72) Erfinder: FESTAG, Mario, D-10555 Berlin (DE); FISCHER, Uwe, D-13086 Berlin (DE); POHNKE, Michael, D-13156 Berlin (DE)
(74) Vertreter: Müller, Wolfram Hubertus, Dr. Dipl.-Phys.
(86) Internationale Anmeldenummer: PCT/DE2000/002747
(87) Internationale Veröffentlichungsnummer: WO 2002/013329

(56) Entgegenhaltungen:
- EP-A- 0 437 931
- EP-A- 1 011 176
- WO-A-00/13054
- US-A- 5 755 595
- US-A- 5 766 041

## Beschreibung

Die Erfindung betrifft ein Schirmblech gemäß dem Oberbegriff des Anspruchs 1, das insbesondere für opto-elektronische Transceivern und mit diesen gekoppelte optische Verbindungselemente geeignet ist.

Es ist bekannt, opto-elektronische Transceiver über optische Steckverbinder an ein optisches Netzwerk anzuschließen. Insbesondere sind sogenannte Small-Form-Factor-(SFF)-Transceiver kleiner Bauart bekannt, die auf einer Leiterplatte angeordnet sind. Eine Einkopplung bzw. Auskopplung von infrarotem Licht in den Transceiver erfolgt über einen am Gehäuse des Transceivers angeordneten Adapter, der eine Steckeraufnahme für einen optischen Stecker besitzt.

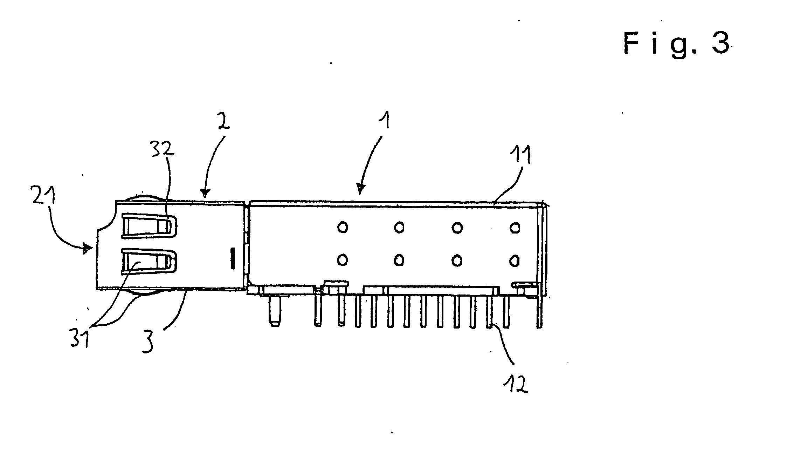

Ein entsprechender Transceiver ist in Figur 3 dargestellt. Der Transceiver 1 ist in einem rechteckigen Gehäuse 11 angeordnet und über Pins 12 in eine Leiterplatte (nicht dargestellt) einsteckbar. Der Transceiver 1 weist in an sich bekannter Weise opto-elektronische Wandler wie einen Fabric Perot Laser oder VCSEL-Laser und eine Fotodiode auf. Eine Ein- bzw. Auskopplung von infrarotem Licht zwischen dem Transceiver 1 und einem optischen Netzwerk erfolgt über einen Adapter 2, der an einer Öffnung an der Frontseite des Gehäuses 11 des Transceivers 1 angeordnet ist. Der Adapter 2 weist eine Öffnung 21 zur Aufnahme eines optischen Steckers auf, so daß ein Lichtwellenleiter an den Transceiver 1 angeschlossen werden kann. Die Steckverbindung ist dabei ähnlich einer RJ-45 Steckverbindung aufgebaut.

Zur elektromagnetischen Abschirmung gegenüber Störemissionen besitzt der Adapter 2 ein umlaufendes Schirmblech 3, das mit dem Gehäuse 11 des Transceivers 1 fluchtet und mit diesem verbunden ist. Zur Erdung ist das Schirmblech 3 über Kontaktfedern 31 mit einer nicht dargestellten metallischen Struktur elektrisch verbunden, etwa der Frontplatte eines Gehäuses, das die Platine mit dem Transceivermodul 1 und weiteren Komponenten enthält.

Zur Ausbildung der Kontaktfedern 31 sind in das Schirmblech 3 Aussparungen 32 gestanzt, wodurch Schlitzstrukturen im Schirmblech 3 entstehen. Durch die Schlitzstrukturen ist die Abschirmwirkung des Schirmblechs nachteilig reduziert, da eine unerwünschte Auskopplung von elektromagnetischen Wellen erfolgt. Dies beruht auf physikalischen Prinzipien, wie sie in analoger Weise in der Hohlleitertechnik zur Verkopplung von Hohlleiterstrukturen durch Löcher und Schlitze Verwendung finden.

Ein SFF-Transceiver gemäß Figur 3 wird von der Infineon Technologies AG hergestellt und ist unter der Bauteilbezeichnung V23818-N15-L17 im Handel erhältlich.

Der vorliegenden Erfindung liegt die Aufgabe zugrunde, ein Schirmblech insbesondere für opto-elektronische Transceiver zur Verfügung zu stellen, das Störemissionen durch elektromagnetische Wellen wirkungsvoll unterdrückt und hierzu eine Auskopplung elektromagnetischer Wellen verhindert.

Diese Aufgabe wird durch ein Schirmblech mit den Merkmalen des Anspruchs 1 gelöst. Bevorzugte und vorteilhafte Ausgestaltungen der Erfindung sind in den Ünteransprüchen angegeben.

Danach zeichnet sich das Schirmblech erfindungsgemäß dadurch aus, daß die Kontaktfedern durch am Hohlkörper stirnseitig angeordnete und auf den Hohlkörper zurückgebogene Fortsätze ausgebildet sind. Die Erfindung ermöglicht es aufgrund der stirnseitigen Anbindung der Kontaktfedern an den Hohlkörper, den Hohlkörper als ein im wesentlichen kontinuierliches Teil auszubilden, das keine oder nur in verminderter Anzahl Aussparungen, Schlitze, etc. aufweist. Dadurch wird eine Auskopplung elektromagnetischer Wellen wirksam verhindert und eine verbesserte Abschirmung zur Verfügung gestellt.

Die erfindungsgemäße Lösung stellt eine Kaminstruktur des Schirmblechs zur Verfügung, die keine Auskopplung elektromagnetischen Wellen durch Ausnehmungen in der Oberfläche des Schirmblechs zuläßt und eine wirksame Abschirmung gegenüber Störemissionen bereitstellt.

Es wird darauf hingewiesen, daß in der bevorzugten Ausgestaltung der Erfindung der Hohlkörper des Schirmblechs als im wesentlichen kontinuierliches Teil ausgebildet ist, das keine Aussparungen, Schlitze etc. besitzt. Die Erfindung eignet sich jedoch auch für Hohlkörper, die zusätzlich Schlitze oder andere Aussparungen aufweisen, wobei die Anzahl der Aussparungen durch die Erfindung zumindest reduziert wird.

Weiter wird darauf hingewiesen, daß unter einem Schirmblech im Sinne der Erfindung ein beliebiges Abschirmelement zu verstehen ist, das sich durch eine hohe Leitfähigkeit sowohl für Gleichstrom als auch für Frequenzen bis in den Bereich von bis zu 10 GHz auszeichnet und damit als Abschirmelement geeignet ist. In der Regel wird das Schirmblech aus einem hoch leitfähigem Blechmaterial bestehen. Jedoch sind auch andere Materialen denkbar.

Der Hohlkörper und die die Kontaktfedern ausbildenden Fortsätze sind bevorzugt einstückig, d.h. als ein Teil ausgebildet. Dies ermöglicht eine einfache Herstellung des Schirmblechs aus einem Teil.

Weiter sind die die Kontaktfedern ausbildenden Fortsätze bevorzugt als kammartige, partielle Verlängerungen des aufgeschnittenen Hohlkörpers ausgebildet. Damit lassen sich Hohlkörper und Fortsätze in einfacher Weise durch Stanzen herstellen. Nach Stanzen eines ebenen Blechteils, das den Hohlkörper und die Fortsätze ausbildet, wird der Hohlkörper auf die gewünschte Hohlkörperform und werden die kammartigen Fortsätze um 180° in Richtung der äußeren Oberfläche des Hohlkörpers gebogen, wodurch die gewünschten Kontaktfedern entstehen, ohne daß der Hohlkörper irgendwelche Ausnehmungen oder Schlitze aufweisen würde.

Bevorzugt setzen die zurückgebogenen Kontaktfedern in einem Bereich des Hohlkörpers, der der mit den Kontaktfedern versehenen Stirnseite abgewandt ist, federn auf die äußere Oberfläche des Hohlkörpers auf. Dies ist insbesondere derjenige Bereich des Hohlkörpers, der an das Gehäuse eines mit dem Hohlkörper bzw. Schirmblech verbundenen Transceivers angrenzt. Durch eine solche Kontaktfederanbindung ergibt sich mit Vorteil ein niederohmiger Übergangswiderstand zu dem,den Transceiver einfassenden Gehäuse.

In einer bevorzugten Ausgestaltung des Schirmblechs weist der Hohlkörper an seiner einen Stirnseite einen Steg auf, der die an dieser Stirnseite durch den Hohlkörper gebildete Öffnung teilt. Der Steg ist aus Symmetriegründen bevorzugt mittig in der Öffnung des Hohlkörpers angeordnet. Durch die Verwendung eines Steges wird die Kaminstruktur bzw. Schirmstruktuir des Schirmblechs und damit die Abschirmung elektromagnetischer Wellen weiter verbessert. Insbesondere verringert der Steg die Auskopplung elektromagnetischer Wellen durch die Öffnung des Hohlkörpers.

Der Hohlkörper des Schirmblechs weist bevozugt die Form des Mantels eines Quaders auf, d.h. erstreckt sich entsprechend den vier Längsbegrenzungsflächen eines Quaders. Jedoch sind in Abhängigkeit von der Form des abzuschirmenden Bereichs auch andere Hohlkörperformen denkbar. Etwa kann der Hohlkörper ebenso die Form eines Zylindermantels aufweisen.

In einer bevorzugten Ausgestaltung ist innerhalb des Schirmblechs zusätzlich ein inneres Schirmblech angeordnet, das mit der inneren Oberfläche des Hohlkörpers in elektrischem Kontakt steht und beispielsweise einen optischen Stecker abschirmt. Das innere Schirmblech dient dabei zum einen der Anbindung eines metallischen LASER-Flansches an das Schirmblech und damit zur Ableitung von auftretenden Störpotentialen an das Schirmblech. Zum anderen wird durch das innere Schirmblech die wirksame Öffnung des durch den Hohlkörper gebildeten "Kamins" und damit der Öffnungsdurchmesser des nichtmetallischen Durchbruchs für LASER- und Empfängerflansch reduziert. Dadurch wird die Cutoff-Frequenz für eventuell durchgreifende elektromagnetische Wellen erhöht und damit die Schirmwirkung im relevanten Frequenzbereich verbessert.

Bevorzugt sind die Kontaktfedern des Schirmblechs nicht direkt mit dem inneren Schirmblech in Verbindung, sondern ist dieses lediglich mit der inneren Oberfläche des Hohlkörpers bzw. Schirmblechs gekoppelt. So besteht aufgrund des Skin-Effekts und aufgrund von Laufzeitunterschieden eine Potentialdifferenz zwischen der Innenseite und der Außenseite des Hohlkörpers.

Wie bereits erwähnt, dient das erfindungsgemäße Schirmblech bevorzugt als Schirmblech eines Adapters oder einer Steckeraufnahme, die einen opto-elektronischen Transceiver mit einem Lichtwellenleiter bzw. optischem Netzwerk koppelt. Für diesen Fall weist der Hohlkörper an seiner mit den Kontaktfedern versehenen Stirnseite eine Aufnahme für einen optischen Stecker auf, und an seiner gegenüberliegenden Stirnseite Mittel zur Befestigung an dem Gehäuse eines opto-elektronischen Transceivers. Das erfindungsgemäße Schirmblech kann jedoch auch in gänzlich anderem Zusammenhang eingesetzt werden.

Die Erfindung wird nachfolgend unter Bezugnahme auf die Figuren der Zeichnung an einem Ausführungsbeispiel näher erläutert. Es zeigen:
- Fig. 1: - eine Draufsicht auf den aufgeschnittenen Hohlkörper eines Schirmblechs mit kammartigen Fortsätzen;
- Fig. 2: - eine perspektivische Ansicht eines erfindungsgemäßen Schirmblechs und
- Fig. 3: - einen Transceiver mit Steckeraufnahme und Schirmblech gemäß dem Stand der Technik.

Zur Erläuterung der Unterschiede zwischen der Erfindung und dem Stand der Technik war eingangs anhand der Figur 3 der Aufbau eines im Stand der Technik bekannten Schirmblechs beschrieben worden.

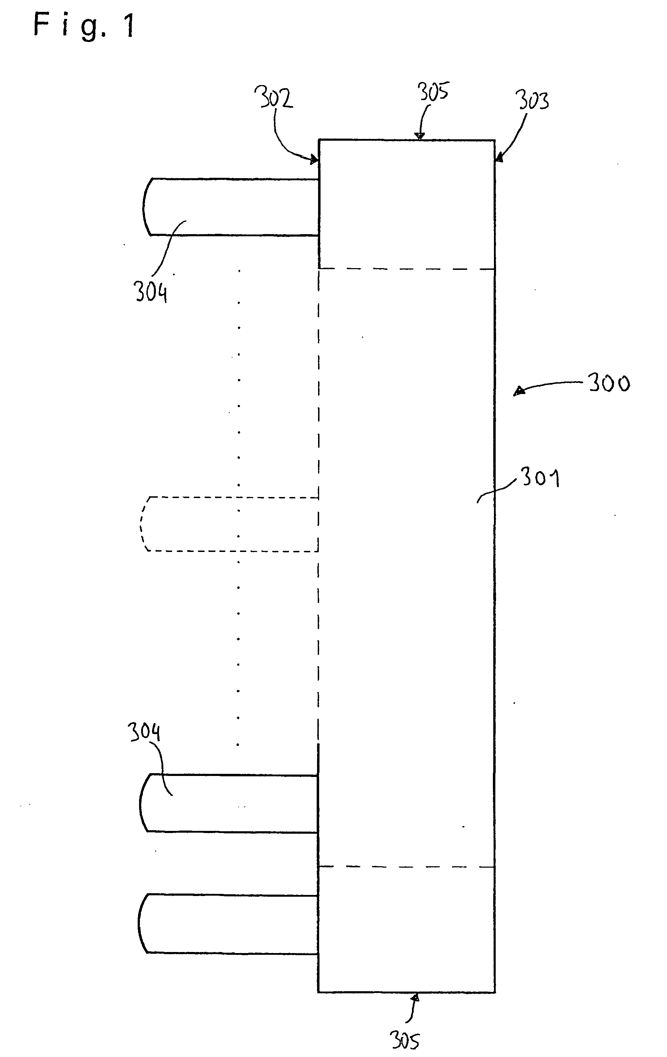

Figur 1 zeigt schematisch ein erfindungsgemäßes Schirmblech 300 im aufgeschnittenen, abgerollten Zustand. Das Schirmblech 300 besitzt einen Hohlkörper 301, der im aufgeschnittenen Zustand gemäß Figur 1 eine rechteckige Form aufweist. Der Hohlkörper 301 weist zwei Stirnseiten 302, 303 auf. Entlang der Stirnseite 302 schließen sich an den Hohlkörper 301 kammartig Fortsätze 304 an, die im wesentlichen rechteckig ausgebildet sind und linienartige Verlängerungen des Hohlkörpers 301 darstellen. Der Hohlkörper 301 und die Fortsätze 304 sind dabei einteilig ausgebildet und werden bevorzugt als Stanzteil hergestellt.

Das für das Schirmblech 300 verwendete Blech weist eine hohe Leitfähigkeit auf, um eine Auskopplung elektromagnetischen Strahlen möglichst zuverlässig zu verhindern.

Zur Herstellung des erfindungsgemäßen Schirmblechs 300 wird der Hohlkörper 301 zu einer gewünschten Hohlkörperform gefaltet und dabei die seitlichen Enden des Hohlkörpers 301 miteinander verbunden. Das Schirmblech 300 erhält dabei bevorzugt eine Quaderform, wobei der Hohlkörper 301 durch entsprechendes Falten die vier Längsbegrenzungsflächen eines Quaders ausbildet. Die Fortsätze 304 werden zur Herstellung von Kontaktfedern um 180° nach hinten umgebogen, wobei die Kontaktfedern die Form von Blattfedern aufweisen.

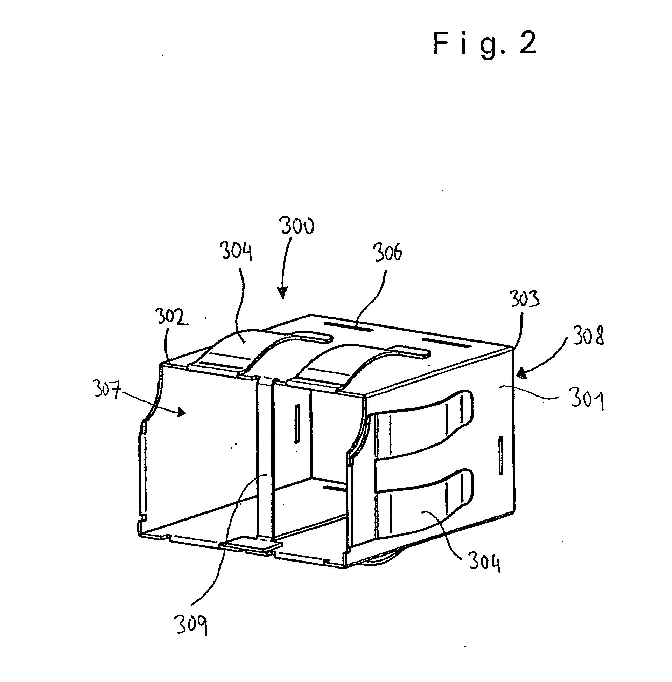

Ein auf diese Weise gefaltetes Schirmblech 300 ist in Figur 2 dargestellt. Der Hohlkörper 301 bildet ein umlaufendes Gehäuse aus, das an beiden Stirnseiten 302, 303 jeweils eine Öffnung 307, 308 aufweist. In der bevorzugten Anwendung des Schirmblechs 300 schließt sich an die hintere Öffnung 308 das Gehäuse eines opto-elektronischen Transceivers gemäß dem Transceiver 1 der Figur 3 an. Zur Befestigung des Schirmblechs am dem Transceivergehäuses sind im Hohlkörper 301 Nuten 306 ausgebildet, in die entsprechende Vorsprünge des Transceivergehäuses einrasten können.

Die vordere Öffnung 307 dient dagegen dem Anschluß eines optischen Steckers, wobei hierzu im Inneren des Schirmblechs 300 eine an sich bekannte Steckeraufnahme (nicht dargestellt) für einen optischen Stecker angeordnet ist. Die Steckeraufnahme ist dabei mit einem inneren Schirmblech umgeben (nicht dargestellt), das in einer Ausführungsform in elektrischem Kontakt mit der inneren Oberfläche des Hohlkörpers 301 steht. Dagegen weisen die Kontaktfedern 304 selbst bevorzugt keinen direkten Kontakt mit dem inneren Schirmblech auf, da zwischen der Innenseite und der Außenseite des Schirmblechs 301 eine Potentialdifferenz besteht, die auf den Skin-Effekt sowie Laufzeitunterschiede zurückzuführen ist.

Die an der Stirnseite 302 des Hohlkörpers 301 ansetzenden Kontaktfedern 304 sind in Richtung auf den Hohlkörper 301 zurückgebogen. Sie sind in einem mittleren Bereich leicht nach außen gewölbt und setzten an ihrem Ende federnd auf das Schirmblech auf. Die Kontaktfedern 304 stehen in Kontakt mit einer nicht dargestellten Blechwand oder anderen metallischen Struktur, die beispielsweise die Frontplatte eines Gehäuses ausbildet. In der Blechwand oder anderen metallischen Struktur ist eine Aussparung ausgebildet, durch die das Abschirmblech 300 durchsteckbar ist, wobei die Kontaktfedern 304 federnd in elektrischem Kontakt mit der Blechwand treten. Die Blechwand schließt das Schirmblech kurz und sorgt für ein festes Potential des Schirmblechs.

Aufgrund der Kaminstruktur des Schirmblechs 300 wird die Entstehung sogenannter Bottlenecks verhindert, die bei einem Schirmblech mit Ausnehmungen vorliegen. Ein Bottleneck ist ein "Flaschenhals", etwa ein dünner Steg zwischen zwei Schlitzen, der strombegrenzend wirkt und für hohe Frequenzen eine Induktivität darstellt, so daß nachteilig eine erhöhte Abstrahlung erfolgt.

Die Kontaktfedern 304 setzten im hinteren Teil des Schirmblechs 300 auf dieses auf, wobei ein zuverlässiger elektrischer Kontakt erzeugt wird. Hierdurch ergibt sich ein niederohmiger Übergangswiderstand zu dem Gehäuse eines sich anschließenden Transceivers.

In der vorderen Öffnung 307 des Schirmblechs 300 ist mittig ein Steg vorgesehen, der die Öffnung 307 teilt. Der Steg 309 verbessert die Kaminstruktur und reduziert durch die resultierenden verringerten Öffnungsdurchmesser weiter eine Auskopplung elektromagnetischer Wellen.

Die Erfindung beschränkt sich in ihrer Ausführung nicht aus das vorstehend beschriebene Ausführungsbeispiel. Wesentlich für die Erfindung ist allein, daß bei einem Abschirmelement die Kontaktfedern durch am Hohlkörper stirnseitig angeordnete und auf den Hohlkörper zurückgebogene Fortsätze ausgebildet sind.

## Patentansprüche

1. Schirmblech, insbesondere für opto-elektronische Transceiver, mit einem mantelförmigen Hohlkörper (301) und am Hohlkörper (301) ausgebildeten Kontaktfedern (304) zur Kontaktierung des Hohlkörpers (301) mit einer metallischen Struktur, wobei die Kontaktfedern stirnseitig angeordnet und auf den Hohlkörper (301) zurückgebogen sind,
**dadurch gekennzeichnet, dass**
die Kontaktfedern (304) durch Fortsätze ausgebildet sind und der Hohlkörper (301) im Bereich der zurückgebogenen Kontaktfedern als kontinierliches Teil ausgebildet ist.

2. Schirmblech nach Anspruch 1, **dadurch gekennzeichnet, daß** die Fortsätze (304) um im wesentlichen 180° auf die äußere Oberfläche des Hohlkörpers (301) zurückgebogen sind.

3. Schirmblech nach Anspruch 1 oder 2, **dadurch gekennzeichnet, daß** die Fortsätze (304) einstückig mit dem Hohlkörper (301) ausgebildet sind.

4. Schirmblech nach mindestens einem der Ansprüche 1 bis 3, **dadurch gekennzeichnet, daß** die Fortsätze (304) eine kammartige, partielle Verlängerung des aufgeschnittenen Hohlkörpers (301) darstellen.

5. Schirmblech nach mindestens einem der Ansprüche 1 bis 4, **dadurch gekennzeichnet, daß** die Fortsätze (304) im wesentlichen rechteckig ausgebildet sind.

6. Schirmblech nach mindestens einem der Ansprüche 1 bis 5, **dadurch gekennzeichnet, daß** die Kontaktfedern (304) an einem Teil des Hohlkörpers (301), der der mit den Kontaktfedern (304) versehenen Stirnseite abgewandt ist, federnd auf den Hohlkörper (301) aufsetzen.

7. Schirmblech nach mindestens einem der Ansprüche 1 bis 6, **gekennzeichnet durch** einen Steg (309), der an einer der Stirnseiten des Hohlkörpers (301) angeordnet ist und die **durch** den Hohlkörper (301) gebildete Öffnung (307) teilt.

8. Schirmblech nach Anspruch 7,
**dadurch gekennzeichnet, daß** der Steg (309) mittig in der Öffnung (307) des Hohlkörpers (301) angeordnet ist.

9. Schirmblech nach mindestens einem der Ansprüche 1 bis 8, **dadurch gekennzeichnet, daß** der Hohlkörper (301) die Form des Mantels eines Quaders oder die Form eines Zylindermantels aufweist.

10. Schirmblech nach mindestens einem der Ansprüche 1 bis 9, **dadurch gekennzeichnet, daß** innerhalb des Schirmblechs (300) zusätzlich ein inneres Schirmblech angeordnet ist, das mit der inneren Oberfläche des Hohlkörpers in elektrischem Kontakt steht.

11. Schirmblech nach mindestens einem der Ansprüche 1 bis 10, **dadurch gekennzeichnet, daß** der Hohlkörper (301) an seiner mit den Kontaktfedern (304) versehenen Stirnseite (302) eine Aufnahme für einen optischen Stecker ausbildet.

12. Schirmblech nach mindestens einem der Ansprüche 1 bis 11, **dadurch gekennzeichnet, daß** der Hohlkörper (301) an der der mit den Kontaktfedern (304) versehenen Stirnseite (308) abgewandten Seite Mittel (306) zur Befestigung des Gehäuses (11) eines opto-elektronischen Transceivers (1) aufweist.

## Claims

1. Screening plate, in particular for optoelectronic transceivers, having a hollow body (301) in the form of a casing and having contact springs (304) which are formed on the hollow body (301) in order to make contact between the hollow body (301) and a metallic structure, the contact springs being arranged on the end face and being bent back onto the hollow body (301),
**characterized in that**
the contact springs (304) are formed by protections and the hollow body (301) is in the form of a continuous part in the region of the bent-back contact springs.

2. The screening plate according to Claim 1, **characterized in that** the projections (304) are bent back through essentially 180° to the outer surface of the hollow body (301).

3. The screening plate according to Claim 1 or 2, **characterized in that** the projections (304) are formed integrally with the hollow body (301).

4. The screening plate according to Claims 1 to 3, **characterized in that** the projections (304) represent a comb-like, partial extension of the cut-open hollow body (301).

5. The screening plate according to at least one of Claims 1 to 4, **characterized in that** the projections (304) essentially have a rectangular shape.

6. The screening plate according to at least one of Claims 1 to 5, **characterized in that** the contact springs (304) touch the hollow body (301) in a sprung manner, on a part of the hollow body (301) which faces away from the end face that is provided with contact springs (304).

7. The screening plate according to at least one of Claims 1 to 6, **characterized by** a web (309) which is arranged on one of the end faces of the hollow body (301) and which divides the opening (307) formed through the hollow body (301).

8. The screening plate according to Claim 7, **characterized in that** the web (309) is arranged centrally in the opening (307) in the hollow body (301).

9. The screening plate according to at least one of Claims 1 to 8, **characterized in that** the hollow body (301) is in the form of the casing of a cuboid or is in the form of a cylindrical casing.

10. The screening plate according to at least one of Claims 1 to 9, **characterized in that** an inner screening plate is also arranged inside the screening plate (300) and makes electrical contact with the inner surface of the hollow body.

11. The screening plate according to at least one of Claims 1 to 10, **characterized in that**, on its end face (302) which is provided with the contact springs (304), the hollow body (301) forms a holder for an optical connector.

12. The screening plate according to at least one of Claims 1 to 11, **characterized in that**, on the side facing away from the end face (308) which is provided with the contact springs (304), the hollow body (301) has means (306) for attaching the housing (11) of an optoelectronic transceiver (1).

## Revendications

1. Tôle de blindage, notamment pour émetteurs-récepteurs optoélectroniques, comprenant un corps creux (301) en forme d'enveloppe et des languettes de ressort de contact (304) réalisées sur le corps creux (301) et destinées à assurer le contact du corps creux (301) avec une structure métallique, les languettes de ressort de contact étant disposées de manière frontale et étant repliées sur le corps creux (301),
**caractérisée en ce que** les languettes de ressort de contact (304) sont réalisées en tant que prolongements, et le corps creux (301) est réalisé sous forme de pièce continue dans la zone des languettes de ressort de contact.

2. Tôle de blindage selon la revendication 1, **caractérisée en ce que** les prolongements (304) sont repliés sensiblement de 180° sur la surface extérieure du corps creux (301).

3. Tôle de blindage selon la revendication 1 ou 2, **caractérisée en ce que** les prolongements (304) sont réalisés d'un seul tenant avec le corps creux (301).

4. Tôle de blindage selon l'une au moins des revendications 1 à 3, **caractérisée en ce que** les prolongements (304) constituent un prolongement partiel, en forme de peigne, du corps creux (301) déployé.

5. Tôle de blindage selon l'une au moins des revendications 1 à 4, **caractérisée en ce que** les prolongements (304) sont sensiblement d'une configuration rectangulaire.

6. Tôle de blindage selon l'une au moins des revendications 1 à 5, **caractérisée en ce que** les languettes de ressort de contact (304) s'appuient de manière élastique sur le corps creux (301), au niveau d'une partie du corps creux (301), qui est éloignée du côté frontal muni des languettes de ressort de contact (304).

7. Tôle de blindage selon l'une au moins des revendications 1 à 6, **caractérisée par** une nervure (309) qui est disposée sur l'un des côtés frontaux du corps creux (301), et divise l'ouverture (307) formée par le corps creux (301).

8. Tôle de blindage selon la revendication 7, **caractérisée en ce que** la nervure (309) est disposée au centre de l'ouverture (307) du corps creux (301).

9. Tôle de blindage selon l'une au moins des revendications 1 à 8, **caractérisée en ce que** le corps creux (301) présente la forme d'une enveloppe d'un parallélépipède ou la forme d'une enveloppe cylindrique.

10. Tôle de blindage selon l'une au moins des revendications 1 à 9, **caractérisée en ce qu'**à l'intérieur de la tôle de blindage (300) est disposée en supplément, une tôle de blindage intérieure qui est en contact électrique avec la surface intérieure du corps creux.

11. Tôle de blindage selon l'une au moins des revendications 1 à 10, **caractérisée en ce que** le corps creux (301) forme sur son côté frontal (302) muni des languettes de ressort de contact (304), un logement pour un connecteur optique.

12. Tôle de blindage selon l'une au moins des revendications 1 à 11, **caractérisée en ce que** le corps creux (301) comporte, sur le côté (308) éloigné du côté frontal muni des languettes de ressort de contact (304), des moyens (306) pour la fixation du carter ou boîtier (11) d'un émetteur-récepteur optoélectronique (1).
